# EUROPÄISCHE PATENTANMELDUNG

(11) **EP 3 690 936 A1**
(43) Veröffentlichungstag der Anmeldung: **05.08.2020**
(21) Anmeldenummer: 19154256.2
(22) Anmeldetag: 29.01.2019
(51) Int. Cl.: H01L 23/488, H01L 21/60

(54) **VERFAHREN ZUM HERSTELLEN EINES SPACER-SYSTEMS MIT CHIPVERTIEFUNG, ENTSPRECHENDES SPACER-SYSTEM UND DESSEN VERWENDUNG ZUR KONTAKTIERUNG EINES CHIPS MIT EINEM SUBSTRAT MITTELS SINTERN**

(71) Anmelder: Heraeus Deutschland GmbH & Co KG, 63450 Hanau (DE)
(72) Erfinder: Klein, Andreas, 63579 Freigericht (DE); Hinrich, Andreas, 63579 Freigericht (DE)
(74) Vertreter: Kilchert, Jochen

(57) **Zusammenfassung**

Die Erfindung betrifft ein Verfahren zum Herstellen eines Spacer-Systems (100, 110) zur Kontaktierung mindestens eines Chips (90) mit einem Substrat (70), umfassend die Schritte:
- Bereitstellen eines elektrisch leitenden Metallelements (10, 10'), das Kupfer umfasst, wobei das Metallelement (10, 10') zwei gegenüberliegend ausgebildete Kontaktierungsseiten (11, 12) aufweist,
- Strukturieren des Metallelements (10, 10'), wobei zumindest auf einer ersten Kontaktierungsseite (11) eine Vertiefung (15) ausgebildet wird,
- Auftragen von Sinterpaste (30) auf die mindestens erste Kontaktierungsseite (11), insbesondere auf beide Kontaktierungsseiten (11, 12), wobei die Vertiefung (15) der ersten Kontaktierungsseite (11) zumindest abschnittsweise mit Sinterpaste (30) gefüllt wird,
- Trocknen der Sinterpaste (30), wobei die Materialdicke der aufgetragenen Sinterpaste (30) reduziert wird.

Auf einer Kontaktierungsseite (11, 12) des Metallelements (10, 10'), insbesondere auf der zweiten Kontaktierungsseite (12), kann zumindest abschnittsweise ein temporäres Vorfixiermittel (31), insbesondere in Form von Klebepunkten, aufgebracht werden. Das Metallelement (10, 10'), das die getrocknete Sinterpaste (35) umfasst, kann auf einem temporären Träger (45) aufgebracht werden, insbesondere derart, dass die zweite Kontaktierungsseite (12) zu dem temporären Träger (45) weist.

Die Erfindung betrifft auch ein entsprechendes Spacer-System (100, 110) und eine Verwendung des Spacer-Systems (100, 110) zur Kontaktierung mindestens eines Chips (90) mit einem Substrat (70), umfassend die Schritte:
- Bereitstellen eines Substrats (70),
- Optionales Ablösen des elektrisch leitenden Metallelements (10, 10') zusammen mit der getrockneten Sinterpaste (35) und optional ausgebildetem Vorfixiermittel (31) von dem temporären Träger (45),
- Aufbringen des elektrisch leitenden Metallelements (10, 10') zusammen mit der getrockneten Sinterpaste (35) und optional ausgebildetem Vorfixiermittel (31) auf dem Substrat (70) derart, dass die zweite Kontaktierungsseite (12) zum Substrat (70) weisend positioniert ist,
- Einsetzen mindestens eines Chips (90) in mindestens eine Kavität (15), die durch die Vertiefung (15) mit der getrockneten Sinterpaste (35) gebildet ist,
- Sintern des Spacer-Systems (100, 110) mit dem Chip (90) und dem Substrat (70).

Ein zweites Spacer-System (110) auf dem mit einem ersten Spacer-System (100) verbundenen Chip (90) kann aufgebracht und mit dem Chip (90) versintert werden.

## Beschreibung

Die Erfindung bezieht sich auf ein Verfahren zum Herstellen eines Spacer-Systems. Des Weiteren betrifft die Erfindung ein Spacer-System, das insbesondere nach einem erfindungsgemäßen Verfahren hergestellt ist. Außerdem betrifft die Erfindung die Verwendung eines Spacer-Systems. Ferner betrifft die Erfindung einen Chip, der mit mindestens einem erfindungsgemäßen Spacer-System verbunden ist.

Steigende Anforderungen hinsichtlich der Leistung und Lebensdauer in Leistungselektronik-Modulen erhöhen die Anforderungen an die Kontaktierung der Leistungshalbleiter sowohl auf der Oberseite als auch auf der Unterseite. Im Stand der Technik sind z.B. Aluminium-Bonddraht-Verbindungen bekannt, die jedoch hinsichtlich der Kontaktierbarkeit an ihre Grenzen stoßen.

Weitere Lösungen hinsichtlich der Kontaktierung von Leistungshalbleitern beruhen auf umfangreichen Biegevorgängen und Strukturierungen. Dabei handelt es sich oftmals um sehr aufwändige Lösungen, die zum einen sehr teuer und zum anderen äußerst kompliziert in der Herstellung sind.

Des Weiteren ist bei der Herstellung von Leistungselektronik-Modulen bei verschiedenen Chips bzw. bei der entsprechenden Verbindung/Kontaktierung von Chips und Substraten mit Höhenunterschieden zu rechnen. Dies bedingt eine entsprechende Nachbearbeitung bei der Herstellung von Leistungselektronik-Modulen. Gleiches gilt im Zusammenhang mit Unterschieden im Bereich der verschiedenen Wärmeausdehnungskoeffizienten von unterschiedlichen Materialien, die zu einem Leistungselektronik-Modul verarbeitet werden sollen.

Ausgehend von diesem Stand der Technik, ist es Aufgabe der vorliegenden Erfindung ein Verfahren zum Herstellen eines Spacer-Systems anzugeben, wobei das Verfahren einfach durchzuführen sein soll und zum anderen auf keinen aufwändigen bzw. teuren Materialien und Verfahrensschritten basieren soll.

Des Weiteren ist es Aufgabe der vorliegenden Erfindung ein weiterentwickeltes Spacer-System zur Verfügung zu stellen, das als Zwischenprodukt dienen kann und für unterschiedliche Arten von Leistungselektronik-Modulen verwendet werden kann.

Ferner ist es Aufgabe der vorliegenden Erfindung eine weiterentwickelte Verwendung eines Spacer-Systems anzugeben. Außerdem ist es Aufgabe der Erfindung, einen Chip mit einem erfindungsgemäßen Spacer-System, anzugeben.

Erfindungsgemäß wird diese Aufgabe mit Blick auf das Verfahren zum Herstellen eines Spacer-Systems durch den Gegenstand des Anspruches 1, mit Blick auf das Spacer-System zur Kontaktierung mindestens eines Chips mit einem Substrat, durch den Gegenstand des Anspruches 6, mit Blick auf die Verwendung eines Spacer-Systems zur Kontaktierung mindestens eines Chips mit einem Substrat durch den Gegenstand des Anspruches 12 und mit Blick auf den Chip durch den Gegenstand des Anspruches 14 gelöst.

Die Erfindung beruht auf dem Gedanken, ein Verfahren zum Herstellen eines Spacer-Systems zur Kontaktierung mindestens eines Chips mit einem Substrat anzugeben, das folgende Schritte umfasst:
- Bereitstellen eines elektrisch leitenden Metallelements, das Kupfer umfasst, wobei das Metallelement zwei gegenüberliegend ausgebildete Kontaktierungsseiten aufweist,
- Strukturieren des Metallelements, wobei zumindest auf einer ersten Kontaktierungsseite eine Vertiefung ausgebildet wird,
- Auftragen von Sinterpaste auf die mindestens erste Kontaktierungsseite, vorzugsweise auf beide Kontaktierungsseiten, wobei die Vertiefung der ersten Kontaktierungsseite zumindest abschnittsweise mit Sinterpaste gefüllt wird,
- Trocknen der Sinterpaste, wobei die Materialdicke der aufgetragenen Sinterpaste reduziert wird.

Das mit Hilfe des erfindungsgemäßen Verfahrens hergestellte Spacer-System dient zur nachfolgenden Kontaktierung mindestens eines Chips mit einem Substrat.

Das elektrisch leitende Metallelement kann in Form einer Metallfolie oder eines Metallbandes, insbesondere in Form eines Metallfolienabschnittes oder in Form eines Metallbandabschnittes, vorliegen. Das elektrisch leitende Metallelement umfasst dabei Kupfer. Es ist möglich, dass das elektrisch leitende Element zumindest eine Schicht aus reinem Kupfer umfasst. Des Weiteren ist es möglich, dass das elektrisch leitende Metallelement mehrere Schichten umfasst, wobei wenigstens eine Schicht Kupfer umfasst und/oder aus Kupfer besteht.

Nach dem Bereitstellen des elektrisch leitenden Metallelementes folgt das Strukturieren des Metallelements, wobei zumindest auf einer ersten Kontaktierungsseite eine Vertiefung ausgebildet wird. Es ist auch möglich, dass auf beiden Kontaktierungsseiten bzw. auf den zwei gegenüberliegenden Kontaktierungsseiten des Metallelements mindestens jeweils eine Vertiefung eingebracht wird. Als Vertiefung ist insbesondere eine derartige Struktur zu verstehen, die keinen vollständigen Durchbruch bzw. kein Loch bildet. Vielmehr handelt es sich bei einer Vertiefung um eine derartige Struktur, die eine Bodenfläche mit Seitenflächen aufweist. Die Vertiefung kann dabei unterschiedliche Formen aufweisen. Die Grundfläche der Vertiefung, d.h. die Bodenfläche der Vertiefung kann dabei eine längliche Form aufweisen. Insbesondere weist die Bodenfläche der Vertiefung eine quadratische oder rechteckige Form auf.

In einer weiteren Ausführungsform der Erfindung ist es möglich, dass auf beiden Seiten des Metallelements, d.h. auf beiden Kontaktierungsseiten, mindestens jeweils eine Vertiefung eingebracht wird, wobei die Vertiefungen in einem derartigen Fall vorzugsweise die gleichen Grundformen aufweisen. Dies erleichtert den Herstellungsprozess. In einer besonderes bevorzugten Ausführungsform der Erfindung sind die Vertiefungen deckungsgleich angeordnet.

Ein Schritt des erfindungsgemäßen Verfahrens umfasst das Auftragen von Sinterpaste mindestens auf die erste Kontaktierungsseite, vorzugsweise auf beiden Kontaktierungsseiten, wobei die in einem vorangegangenen Verfahrensschritt eingearbeitete Vertiefung mit der Sinterpaste gefüllt wird. Es ist möglich, dass zusätzliche Flächen des Metallelements, insbesondere die weitere Kontaktierungsseite, die möglicherweise keine Vertiefung aufweist, ebenfalls mit Sinterpaste versehen wird bzw. dort entsprechende Sinterpaste aufgetragen wird.

Die Vertiefung der ersten Kontaktierungsseite wird zumindest abschnittsweise mit Sinterpaste gefüllt. Das bedeutet, dass keine vollständige Füllung der gesamten Vertiefung mit Sinterpaste erfolgt. Vorzugsweise wird die Sinterpaste in die mindestens eine Vertiefung derart eingebracht, dass die vollständige Bodenfläche der Vertiefung mit Sinterpaste beschichtet ist. Die Vertiefung muss jedoch nicht zwangsläufig vollständig, d.h. über ihre gesamte Tiefe hinweg mit Sinterpaste gefüllt sein.

In Abhängigkeit der zu verwendenden Sinterpaste kann es jedoch vorgesehen sein, dass die Vertiefung vollständig mit Sinterpaste gefüllt wird oder die Sinterpaste derart aufgetragen wird, dass die in die Vertiefung eingebrachte Sinterpaste über den Vertiefungsrand hinweg vorsteht. Mit anderen Worten kann die Sinterpaste über die erste Kontaktierungsseite auch im Bereich der Vertiefung überstehen. In einem nachfolgenden Trocknungsschritt wird die Materialdicke der aufgetragenen Sinterpaste entsprechend reduziert. Die Trocknung der Sinterpaste erfolgt vorzugsweise derart, dass die Vertiefung mit der aufgetragenen und getrockneten Sinterpaste wiederum seitliche Randbereiche der Vertiefung freigibt, so dass die Vertiefung mit der aufgebrachten und getrockneten Sinterpaste selbst eine Kavität bildet.

Aufgrund der zumindest abschnittsweise in einer Vertiefung befindlichen Sinterpaste kann eine Kavität gebildet werden, die eine spätere Platzierung eines Chips vereinfacht.

Es ist möglich, dass das strukturierte Metallelement vor dem Auftragen von Sinterpaste metallisiert, insbesondere galvanisiert, wird.

In einer weiteren Ausführungsform des erfindungsgemäßen Verfahrens ist es möglich, dass auf einer Kontaktierungsseite, insbesondere auf der zweiten Kontaktierungsseite, zumindest abschnittsweise ein temporäres Vorfixiermittel aufgebracht wird. Das temporäre Vorfixiermittel wird insbesondere auf der Kontaktierungsseite des Metallelements aufgebracht, die keine mit Sinterpaste gefüllte Vertiefung aufweist.

Es ist möglich, dass das Metallelement, das getrocknete Sinterpaste umfasst, auf einem temporären Träger aufgebracht wird. Insbesondere handelt es sich bei dem Metallelement in diesem Fall um mehrere zusammenhängende Metallelementteile, die auf dem Träger liegend vereinzelt werden können. Es ist auch möglich, dass ein bereits vereinzeltes Metallelement auf einem temporären Träger aufgebracht oder platziert wird.

In einer besonders bevorzugten Ausführungsform der Erfindung wird das Metallelement mit der getrockneten Sinterpaste derart auf den temporären Träger aufgebracht, dass die zweite Kontaktierungsseite zu dem temporären Träger weist. Bei der zweiten Kontaktierungsseite handelt es sich folglich um die Seite des Metallelements, das optional keine Vertiefung jedoch möglicherweise ein temporäres Vorfixiermittel aufweist.

Bei dem temporären Träger kann es sich um einen Wafer-Frame oder um einen Teil eines Wafer-Frames handeln. Dieser Wafer-Frame weist vorzugsweise eine spezielle Folie auf. Im Rahmen eines Pick-and-Place-Prozesses kann das strukturierte Metallelement wieder von dem temporären Träger abgenommen werden. Das Zwischenprodukt kann unter Umständen bereits mit einem Chip versehen sein. Der Chip ist dabei auf dem Sintermaterial aufgebracht, das zumindest abschnittsweise in der Vertiefung ausgebildet ist.

Des Weiteren ist es möglich, dass ein Metallelement, das getrocknete Sinterpaste aufweist, in einem Waffle Pack verpackt und transportiert wird.

Insgesamt ist zu erkennen, dass das erfindungsgemäße Verfahren zum Herstellen eines Spacer-Systems zur Kontaktierung mindestens eines Chips mit einem Substrat äußerst einfach ausgeführt werden kann. Das erfindungsgemäße Verfahren ist für eine Vielzahl von unterschiedlichen Spacer-Systemen geeignet.

Gemäß einem weiteren, insbesondere nebengeordneten, Aspekt der Erfindung wird ein Spacer-System zur Kontaktierung mindestens eines Chips mit einem Substrat angegeben. Insbesondere handelt es sich dabei um ein erfindungsgemäß hergestelltes Spacer-System.

Bei einem Spacer-System handelt es sich mit anderen Worten um ein Abstandshalter-System. Das Spacer-System umfasst ein elektrisch leitendes Metallelement, das Kupfer umfasst und zwei gegenüberliegend ausgebildete Kontaktierungsseiten aufweist, wobei auf mindestens einer ersten Kontaktierungsseite eine Vertiefung ausgebildet ist und auf beiden Kontaktierungsseiten getrocknete Sinterpaste ausgebildet ist.

Die Vertiefung ist abschnittsweise mit getrockneter Sinterpaste gefüllt, derart, dass die Vertiefung mit der getrockneten Sinterpaste eine Kavität bildet, wobei das Spacer-System auf einem temporären Träger aufgebracht ist. Hinsichtlich des Spacer-Systems gelten die bereits im Zusammenhang mit dem erfindungsgemäßen Verfahren angegebenen Erläuterungen.

Das elektrisch leitende Metallelement umfasst zumindest eine Schicht mit Kupfer oder einer Kupferlegierung. Mit anderen Worten weist mindestens eine Schicht des elektrisch leitenden Metallelements ein Kupfermaterial auf. Des Weiteren kann das elektrisch leitende Metallelement ein Molybdän-Kupfer-Material (MoCu) und/oder ein Wolfram-Kupfer-Material (WCu) und/oder ein Kupfer-Molybdän-Kupfer-Verbundwerkstoff (CuMoCu) sein.

Bei der Sinterpaste handelt es sich vorzugsweise um eine Silbersinterpaste. Die getrocknete Silbersinterpaste weist vorzugsweise eine Rest-Reaktivität auf, derart, dass die bereits aufgebrachte und getrocknete, insbesondere vorgetrocknete, Silbersinterpaste bei Durchführen eines nachfolgenden Sinterprozesses eine entsprechende Verbindung zu einem Chip und/oder einem Substrat herstellen kann.

Auf der zweiten Kontaktierungsseite ist vorzugsweise zumindest abschnittsweise ein temporäres Vorfixiermittel, insbesondere in Form von Klebepunkten, ausgebildet.

Bei dem Vorfixiermittel kann es sich beispielsweise um einen Klebstoff handeln. Des Weiteren ist es möglich, dass es sich bei dem Vorfixiermittel um einen druckaktivierbaren Klebstoff handelt.

Außerdem ist es möglich, dass das Vorfixiermittel flächig, beispielsweise streifenförmig, auf mindestens eine Kontaktierungsseite, insbesondere auf die zweite Kontaktierungsseite aufgebracht wird. Vorzugsweise ist das Vorfixiermittel auf der Seite des Spacer-Systems aufgebracht, das keine Vertiefung mit darin befindlichem Sinterpasten-Material aufweist.

Des Weiteren ist es bevorzugt, dass das temporäre Vorfixiermittel seitlich einer Sinterpaste auf der zweiten Kontaktierungsseite ausgebildet ist. Es ist möglich, dass ein flächiger Abschnitt, beispielsweise streifenförmig oder quadratisch oder rechteckig, der zweiten Kontaktierungsseite mit einer Sinterpaste beschichtet wird. Das temporäre Vorfixiermittel kann demnach als seitliche Umrandung dieser Sinterpaste bzw. des Sinterpastenabschnittes, ausgebildet sein. Dabei kann das temporäre Vorfixiermittel zu dem Sinterpastenabschnitt beabstandet ausgebildet sein.

Um eine ausreichende Vorfixierung zu ermöglichen, weist das optional ausgebildete temporäre Vorfixiermittel vorzugsweise eine größere Materialdicke als die Sinterpaste auf. Mit anderen Worten kann das temporäre Vorfixiermittel über die Sinterpaste vorstehen, so dass eine Fixierung des Metallelements an einem weiteren Bauteil, insbesondere an einem temporären Träger und/oder an einem Substrat, ermöglicht wird.

Die mindestens eine Kavität des Spacer-Systems kann durch einen getrockneten Sinterpastenabschnitt und Innenseitenkanten des Metallelements gebildet sein. Bei den Innenseitenkanten des Metallelements handelt es sich um Abschnitte der Innenseitenkanten einer in das Metallelement eingebrachten Vertiefung. Die Kavität dient folglich als Fixierabschnitt. Ein in die Kavität eingebrachtes bzw. aufgelegtes Halbleiterelement, insbesondere ein Chip, kann in einer derartigen Kavität bereits vor dem tatsächlichen Sinterschritt nicht mehr leicht verrutschen.

Aufgrund des erfindungsgemäßen Spacer-Systems können Höhenunterschiede oder herstellungstechnische Unterschiede aufgrund unterschiedlicher Wärmeausdehnungskoeffizienten der verwendeten Materialien sowohl auf einer Halbleiter- oder Chip-Oberseite als auch unter dem Halbleiterelement bzw. unter einem Chip ausgeglichen werden. Dies kann beispielsweise der Fall sein, sofern unterschiedliche Chips, wie z.B. IGBT und Dioden, oberseitig mit einem Kupfer-Leadframe kontaktiert werden, der Gate-Kontakt jedoch mit einem Wire-Bond ausgeführt wird. Ein in einem derartigen Fall verwendeter Bond-Loop weist eine gewisse Höhe auf und darf das obere Leadframe nicht berühren.

Das Strukturieren des Metallelements, insbesondere das Ausbilden oder Einbringen einer Vertiefung auf die erste Kontaktierungsseite des Metallelements kann insbesondere durch einen Prägevorgang durchgeführt werden.

Aufgrund der ausgebildeten Vertiefung kann die Sinterpaste in einfacher Art und Weise in die Vertiefung eingebracht werden. Beispielsweise kann die Sinterpaste in die Vertiefung mittels eines Rakelvorgangs in die Vertiefung eingebracht werden.

Vorzugsweise ist die Kavität des Spacer-Systems derart ausgebildet, d.h. die Kavität weist eine derartige Höhe auf, dass vor dem Bestücken der Kavität mit einem Chip in die Kavität ein Klebstoff, beispielsweise ein Sinter-Kleber oder ein Polymer in die Kavität eingebracht werden kann. Ein derartiger Klebstoff kann beispielsweise durch Dispensen oder Jetten in die Kavität eingebracht werden. Das Einbringen von Klebstoff in die Kavität hat den Vorteil, dass keine Hohlräume zwischen dem Chip und dem Metallelement gebildet werden. Ein abschließendes Moulden und/oder Spritzgießen und/oder Vergießen kann folglich störungsfrei erfolgen.

Ein weiterer, insbesondere nebengeordneter, Aspekt der Erfindung betrifft die Verwendung eines erfindungsgemäßen Spacer-Systems zur Kontaktierung mindestens eines Chips mit einem Substrat. Die Verwendung umfasst dabei die Schritte:
- Bereitstellen eines Substrats,
- Ablösen des elektrisch leitenden Metallelements zusammen mit der getrockneten Sinterpaste und optional ausgebildetem Vorfixiermittel von einem/dem temporären Träger,
- Aufbringen des elektrisch leitenden Metallelements zusammen mit der getrockneten Sinterpaste und optional ausgebildetem Vorfixiermittel auf dem Substrat derart, dass die zweite Kontaktierungsseite zum Substrat weisend positioniert ist,
- Einsetzen mindestens eines Chips in die mindestens eine Kavität,
- Sintern des Spacer-Systems mit dem Chip und dem Substrat.

Die erfindungsgemäße Verwendung kann des Weiteren die Verwendung eines zweiten Spacer-Systems umfassen, wobei das zweite Spacer-System auf dem mit einem ersten Spacer-System verbundenen Chip aufgebracht wird und mit dem Chip versintert wird.

Mit Hilfe des erfindungsgemäßen Spacer-Systems oder mit Hilfe der erfindungsgemäßen Verwendung eines Spacer-Systems können Höhenunterschiede der unterschiedlichen Bauteile ausgeglichen werden. Die anschließende oberseitige Kontaktierung kann einfach und kostengünstig durch Standardbauteile hergestellt werden. Insbesondere ist es möglich, einfache Leadframes oder DCBs zur oberseitigen Kontaktierung zu verwenden.

Mit Hilfe des Spacer-Systems kann außerdem zusätzlicher Raum für Bonddraht-Verbindungen hergestellt werden. Derartige Bonddraht-Verbindungen sind insbesondere zur Gate-Kontaktierung möglich.

Des Weiteren kann der CTE (coefficient of thermal expansion) bzw. der Ausdehnungskoeffizient durch entsprechende Materialauswahl angepasst werden. Außerdem hat das Spacer-System als Zwischenprodukt den Vorteil, dass dieses von einem Leistungselektronik-Modul-Hersteller direkt vom Träger abgenommen und entsprechend weiterverarbeitet werden kann. Dies kann insbesondere zeitgleich mit einem Die Attach erfolgen.

Ein weiterer Aspekt der Erfindung betrifft einen Chip, der mit einem erfindungsgemäßen Spacer-System verbunden ist. Der Chip ist in einer Kavität des Spacer-Systems befindlich und mittels der Sinterpaste und optional weiteren Fixiermitteln mit dem Spacer-System verbunden.

Des Weiteren ist es möglich, dass ein Chip mit zwei erfindungsgemäßen Spacer-Systemen verbunden ist oder in Verbindung steht. Mit anderen Worten ist in einem derartigen Fall vorzugsweise jede Chip-Kontaktierungsseite mit einem erfindungsgemäßen Spacer-System verbunden.

Die Kavität bildet eine Fixierhilfe und/oder eine Bestückungshilfe. Insbesondere im Zusammenhang mit automatisierten Bestückungsvorgängen kann eine Kavität auch als Bestückungshilfe dienen. Eine derartige Kavität kann von optischen Erfassungssystemen einfach detektiert werden. Dies kann beispielsweise mittels eines Laserscanners erfolgen.

Nachfolgend wird die Erfindung anhand von Ausführungsbeispielen unter Bezug auf die beigefügten Zeichnungen näher erläutert.

In diesen zeigen:
- Fig. 1a-1e: einzelne Schritte eines erfindungsgemäßen Verfahrens zum Herstellen eines Spacer-Systems; und
- Fig. 2a-2c: einzelne Schritte einer erfindungsgemäßen Verwendung eines erfindungsgemäßen Spacer-Systems.

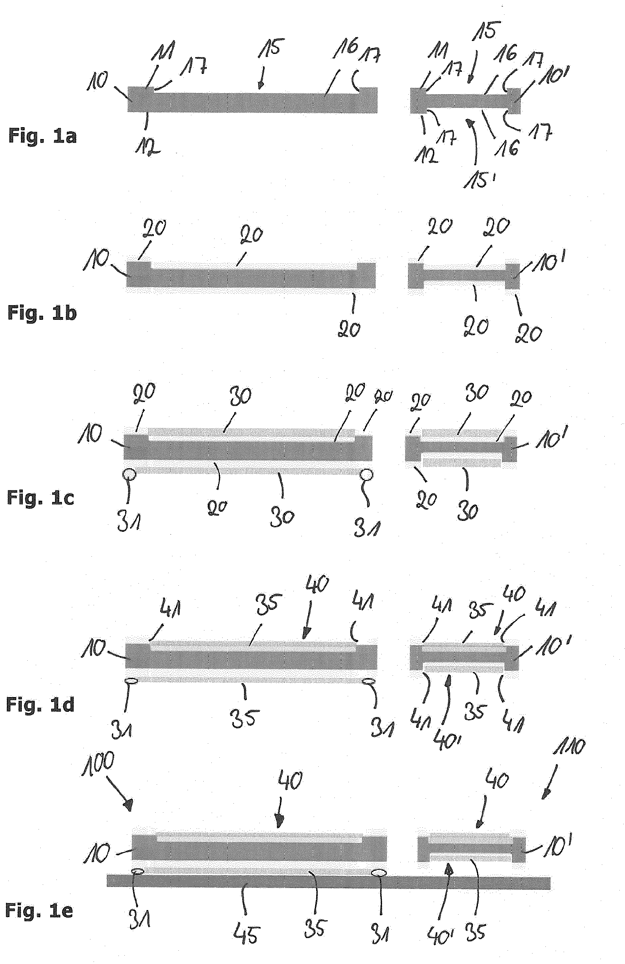

Fig. 1a zeigt bereitgestellte elektrisch leitende Metallelemente 10 und 10', die jeweils zur Herstellung von Spacer-Systemen dienen. Bei den elektrisch leitenden Metallelementen 10 und 10' handelt es sich um derartige Metallelemente, die zumindest eine Schicht mit Kupfer oder einer Kupferlegierung umfassen. Des Weiteren ist es möglich, dass die elektrisch leitenden Metallelemente ein Molybdän-Kupfer-Material und/oder ein Wolfram-Kupfer-Material und/oder einen Kupfer-Molybdän-Kupfer-Verbundwerkstoff umfassen.

Beide Metallelemente 10 und 10' weisen jeweils eine erste Kontaktierungsseite 11 und eine zweite Kontaktierungsseite 12 auf. Das Metallelement 10 weist auf der ersten Kontaktierungsseite 11 eine Vertiefung 15 auf. Auch das Metallelement 10' weist eine derartige Vertiefung 15 auf der ersten Kontaktierungsseite 11 auf. Die zweite Kontaktierungsseite 12 des Metallelements 10 weist hingegen keine Vertiefung auf.

Das Metallelement 10' weist auf der zweiten Kontaktierungsseite 12 eine weitere Vertiefung 15' auf. Die Vertiefung 15' der zweiten Kontaktierungsseite 12 ist deckungsgleich zur Vertiefung 15 der ersten Kontaktierungsseite 11 ausgebildet. Die Vertiefungen 15 und 15' werden jeweils von einer Bodenfläche 16 und (Innen)Seitenkanten 17 gebildet.

Wie in Fig. 1b dargestellt ist, können die Metallelemente 10 und 10' beschichtet sein. Die Beschichtung 20 ist dabei sowohl auf den Kontaktierungsseiten 11 und 12 als auch in den Vertiefungen 15 und 15' ausgebildet. Dies betrifft im Zusammenhang mit den Vertiefungen 15 und 15' sowohl die Bodenflächen 16 als auch die Seitenkanten 17. Das Beschichten erfolgt vorzugsweise im Rahmen eines Galvanisierungsprozesses. Die Beschichtung 20 kann beispielsweise eine Korrosionsbeständigkeit als auch eine verbesserte Verbindung einer später aufzutragenden Sinterpaste bewirken.

In Fig. 1c ist dargestellt, dass auf beiden Seiten 11 und 12 der Metallelemente 10 und 10' eine Sinterpaste 30 aufgetragen wird. Die Sinterpaste 30 wird insbesondere in die Vertiefungen 15 und 15' eingebracht. Bei dem Metallelement 10 wird die Sinterpaste 30 auch auf die zweite Kontaktierungsseite 12 aufgetragen. Die Sinterpaste 30 ist vorzugsweise eine Silbersinterpaste.

Zum Auftragen in die Vertiefungen 15 und 15' kann beispielsweise ein Rakelverfahren angewendet werden. Die Sinterpaste 30 kann folglich in die Vertiefungen 15 und 15' mit Hilfe eines Rakels eingestrichen werden. Im zunächst lediglich aufgetragenen bzw. eingefüllten Zustand der Sinterpaste 30 weist die Sinterpaste 30 eine derartige Materialdicke auf, so dass die Vertiefungen 15 und 15' vollständig mit Sinterpaste 30 befüllt sind.

Auf der zweiten Kontaktierungsseite 12 des Metallelements 10 ist außerdem ein Vorfixiermittel 31 aufgebracht. Das Vorfixiermittel 31 ist beispielsweise ein Klebemittel. Das Vorfixiermittel 31 kann in Form von Klebepunkten aufgebracht sein. Insbesondere ist das Vorfixiermittel 31 seitlich der Sinterpaste 30 auf der zweiten Kontaktierungsseite 12 aufgebracht.

In Fig. 1d sind die Metallelemente 10 und 10' in einem getrockneten Zustand dargestellt. Aufgrund des Trocknungsvorganges nimmt die Materialdicke der Sinterpaste 30 ab. Aufgrund der Verringerung der Dicken werden im Zusammenhang mit den Vertiefungen 15 und 15' Kavitäten 40, 40' gebildet. Die Kavitäten 40, 40' werden dabei durch die getrocknete Sinterpaste 35 und die wieder freigelegten Innenseitenkanten 41 der Vertiefungen 15 und 15' gebildet.

Aufgrund des Trocknungsprozesses werden auch die in Punktform aufgetragenen Vorfixiermittel 31 im Zusammenhang mit ihrer Höhe verringert. Allerdings weist das temporäre Vorfixiermittel auch in getrocknetem Zustand eine größere Materialdicke auf als die getrocknete Sinterpaste 35.

In Fig. 1d wird dargestellt, dass die Metallelemente 10 und 10', die sowohl getrocknete Sinterpasten 35 als auch ein Vorfixiermittel 31 umfassen, auf einem temporären Träger 45 platziert werden. In dieser Form bilden die Metallelemente 10 und 10' zusammen mit dem temporären Träger 45 ein Spacer-System 100 bzw. 110. In diesem Zustand können die Spacer-Systeme 100 und 110 zu einem weiteren Herstellungsort transportiert werden bzw. zu einem Kunden oder Hersteller von Leistungselektronik-Modulen. Bei dem temporären Träger 45 handelt es sich um einen Film-Frame.

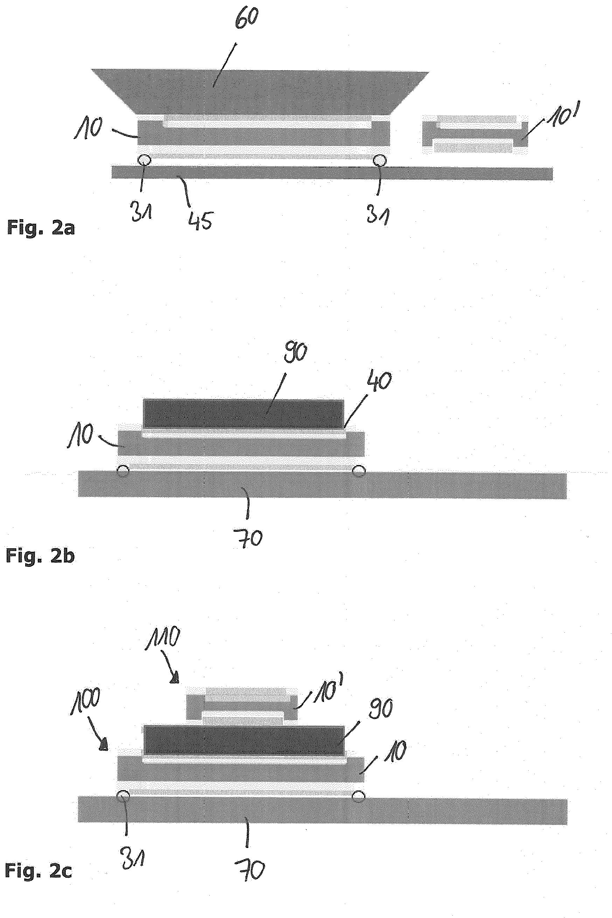

In den Fig. 2a - 2c wird die weitere Verwendung von Spacer-Systemen 100 und 110 dargestellt. Im Rahmen eines Pick-and-Place-Prozesses werden sowohl das Spacer-System 100 als auch das Spacer-System 110 vom temporären Träger 45 gelöst. Dies kann mit Hilfe einer Düse 60 erfolgen.

Zunächst wird das Spacer-System 100, das lediglich eine Vertiefung 15 auf der ersten Kontaktierungsseite 11 aufweist auf einem Substrat 70 platziert. In die Kavität 40 kann anschließend ein Chip 90 gesetzt werden. Die Kavität 40 dient als Bestückhilfe oder als Fixierhilfe. Im noch unversinterten Zustand kann der Chip 90 zumindest seitlich nicht verrutschen, so dass eine temporäre Fixierung des Chips 90 in der Kavität 40 erfolgt.

Vor dem Aufsetzen des Chips 90 in die Kavität 40 kann die Kavität außerdem zusätzlich mit einem Kleber, insbesondere einem Sinter-Kleber oder einem Polymer, aufgefüllt werden. Ein derart aufgebrachtes Klebemittel kann beispielsweise mittels Dispensen oder Jetten aufgebracht werden. Dies bewirkt, dass keine Hohlräume zwischen dem Chip 90 und dem Metallelement 10 gebildet werden.

Auf den Chip 90 kann, wie dies in Fig. 2c dargestellt wird, anschließend das Spacer-System 110 aufgesetzt werden. Die zweite Kontaktierungsseite 12 mit der darin ausgebildeten Vertiefung 15' wird dabei auf den Chip 90 aufgebracht. Aufgrund der in der Vertiefung 15' ausgebildeten und zwischenzeitlich getrockneten Sinterpaste 35 kann somit eine Kontaktierung, nämlich eine obere Kontaktierung, des Chips 90 mit Hilfe des Spacer-Systems 110 vorgenommen werden.

In der in Fig. 2c dargestellten Form kann der Chip zusammen mit den Spacer-Systemen 100 und 110 mit dem Substrat versintert werden. Insbesondere aufgrund der in Fig. 2a - 2c dargestellten Verfahrensschritte wird klar, dass mit Hilfe der erfindungsgemäßen Spacer-Systeme 100, 110 und aufgrund der erfindungsgemäßen Verwendung dieser Spacer-Systeme 100 und 110 Höhenunterschiede zwischen verschiedenen Elementen eines herzustellenden Leistungselektronik-Moduls in einfacher Art und Weise ausgeglichen werden können.

Die Erfindung ist nicht durch die Beschreibung anhand der Ausführungsbeispiele auf diese beschränkt. Vielmehr umfasst die Erfindung jedes neue Merkmal sowie die Kombination von Merkmalen, wobei dies insbesondere jede Kombination von Merkmalen der Ansprüche beinhaltet, auch wenn dieses Merkmal oder diese Kombination selbst nicht explizit in den Ansprüchen oder Ausführungsbeispielen angegeben ist.

### Bezugszeichenliste

- 10, 10': Metallelement
- 11: Erste Kontaktierungsseite
- 12: Zweite Kontaktierungsseite
- 15, 15': Vertiefung
- 16: Bodenfläche
- 17: Seitenkante
- 20: Beschichtung
- 30: Sinterpaste
- 31: Vorfixiermittel
- 35: Getrocknete Sinterpaste
- 40: Kavität
- 41: Innenseitenkante
- 45: Temporärer Träger
- 60: Düse
- 70: Substrat
- 90: Chip
- 100: Spacer-System
- 110: Spacer-System

## Patentansprüche

1. Verfahren zum Herstellen eines Spacer-Systems (100, 110) zur Kontaktierung mindestens eines Chips (90) mit einem Substrat (70), umfassend die Schritte:
- Bereitstellen eines elektrisch leitenden Metallelements (10, 10'), das Kupfer umfasst, wobei das Metallelement (10, 10') zwei gegenüberliegend ausgebildete Kontaktierungsseiten (11, 12) aufweist,
- Strukturieren des Metallelements (10, 10'), wobei zumindest auf einer ersten Kontaktierungsseite (11) eine Vertiefung (15) ausgebildet wird,
- Auftragen von Sinterpaste (30) auf die mindestens erste Kontaktierungsseite (11), vorzugsweise auf beide Kontaktierungsseiten (11, 12), wobei die Vertiefung (15) der ersten Kontaktierungsseite (11) zumindest abschnittsweise mit Sinterpaste (30) gefüllt wird,
- Trocknen der Sinterpaste (30), wobei die Materialdicke der aufgetragenen Sinterpaste (30) reduziert wird.

2. Verfahren nach Anspruch 1,
**dadurch gekennzeichnet, dass**
das strukturierte Metallelement (10, 10') vor dem Auftragen von Sinterpaste (30) metallisiert, insbesondere galvanisiert, wird.

3. Verfahren nach Anspruch 1 oder 2,
**dadurch gekennzeichnet, dass**
auf einer Kontaktierungsseite (11, 12), insbesondere auf der zweiten Kontaktierungsseite (12), zumindest abschnittsweise ein temporäres Vorfixiermittel (31) aufgebracht wird.

4. Verfahren nach einem der Ansprüche 1 bis 3,
**dadurch gekennzeichnet, dass**
das Metallelement (10, 10'), das getrocknete Sinterpaste (35) umfasst, auf einem temporären Träger (45) aufgebracht wird.

5. Verfahren nach Anspruch 4,
**dadurch gekennzeichnet, dass**
das Metallelement (10, 10') derart auf dem temporären Träger (45) aufgebracht wird, dass die zweite Kontaktierungsseite (12) zu dem temporären Träger (45) weist.

6. Spacer-System (100, 110) zur Kontaktierung mindestens eines Chips (90) mit einem Substrat (70), insbesondere hergestellt nach einem Verfahren nach einem der Ansprüche 1 bis 5,
umfassend ein elektrisch leitendes Metallelement (10, 10'), das Kupfer umfasst und zwei gegenüberliegend ausgebildete Kontaktierungsseiten (11, 12) aufweist,
wobei auf mindestens einer ersten Kontaktierungsseite (11) eine Vertiefung (15) ausgebildet ist und mindestens auf der ersten Kontaktierungsseite (11), vorzugsweise auf beiden Kontaktierungsseiten (11, 12), getrocknete Sinterpaste (35) ausgebildet ist,
wobei die Vertiefung (15) abschnittsweise mit getrockneter Sinterpaste (35) gefüllt ist, derart, dass die Vertiefung (15) mit der getrockneten Sinterpaste (35) eine Kavität (40) bildet,
wobei das Spacer-System (100, 110) vorzugsweise auf einem temporären Träger (45) aufgebracht ist.

7. Spacer-System (100, 110) nach Anspruch 6,
**dadurch gekennzeichnet, dass**
das elektrisch leitende Metallelement (10, 10') zumindest eine Schicht mit Kupfer oder einer Kupferlegierung umfasst und/oder ein Molybdän-Kupfer-Material (MoCu) ist und/oder ein Wolfram-Kupfer-Material (WCu) ist und/oder ein Kupfer-Molybdän-Kupfer-Verbundwerkstoff (CuMoCu) ist.

8. Spacer-System (100, 110) nach Anspruch 6 oder 7,
**dadurch gekennzeichnet, dass**
die getrocknete Sinterpaste (35) eine Silbersinterpaste ist.

9. Spacer-System (100, 110) nach einem der Ansprüche 6 bis 8,
**dadurch gekennzeichnet, dass**
auf der zweiten Kontaktierungsseite (12) zumindest abschnittsweise ein temporäres Vorfixiermittel (31), insbesondere in Form von Klebepunkten, ausgebildet ist.

10. Spacer-System (100, 110) nach Anspruch 9,
**dadurch gekennzeichnet, dass**
das temporäre Vorfixiermittel (31) seitlich einer/der getrockneten Sinterpaste (35) auf der zweiten Kontaktierungsseite (12) ausgebildet ist und vorzugsweise eine größere Materialdicke als die Sinterpaste (35) aufweist.

11. Spacer-System (100, 110) nach einem der Ansprüche 6 bis 10,
**dadurch gekennzeichnet, dass**
die mindestens eine Kavität (40) durch einen getrockneten Sinterpastenabschnitt (35) und Innenseitenkanten (41) des Metallelements (10, 10') gebildet ist.

12. Verwendung eines Spacer-Systems (100, 110) nach einem der Ansprüche 6 bis 11 zur Kontaktierung mindestens eines Chips (90) mit einem Substrat (70), umfassend die Schritte:
- Bereitstellen eines Substrats (70),
- Optionales Ablösen des elektrisch leitenden Metallelements (10, 10') zusammen mit der getrockneten Sinterpaste (35) und optional ausgebildetem Vorfixiermittel (31) von einem/dem temporären Träger (45),
- Aufbringen des elektrisch leitenden Metallelements (10, 10') zusammen mit der getrockneten Sinterpaste (35) und optional ausgebildetem Vorfixiermittel (31) auf dem Substrat (70) derart, dass die zweite Kontaktierungsseite (12) zum Substrat (70) weisend positioniert ist,
- Einsetzen mindestens eines Chips (90) in die mindestens eine Kavität (15),
- Sintern des Spacer-Systems (100, 110) mit dem Chip (90) und dem Substrat (70).

13. Verwendung nach Anspruch 12,
**dadurch gekennzeichnet, dass**
ein zweites Spacer-System (110) auf dem mit einem ersten Spacer-System (100) verbundenen Chip (90) aufgebracht wird und mit dem Chip (90) versintert wird.

14. Chip (90), der mit mindestens einem Spacer-System (100, 110) nach einem der Ansprüche 6 bis 11 verbunden ist.
